(19) Europäisches Patentamt
European Patent Office
Office européen des brevets

(11) Veröffentlichungsnummer: **0 039 829**
**B1**

# (12) EUROPÄISCHE PATENTSCHRIFT

(45) Veröffentlichungstag der Patentschrift: **11.01.84**

(51) Int. Cl.³: **H 01 B 1/12**

(21) Anmeldenummer: **81103210.1**

(22) Anmeldetag: **29.04.81**

(54) **Verfahren zur Herstellung elektrisch leitfähiger löslicher Heteropolyphenylene und deren Verwendung in der Elektrotechnik und zur antistatischen Ausrüstung von Kunststoffen.**

(30) Priorität: **14.05.80 DE 3018459**

(43) Veröffentlichungstag der Anmeldung: **18.11.81 Patentblatt 81/46**

(45) Bekanntmachung des Hinweises auf die Patenterteilung: **11.01.84 Patentblatt 84/2**

(84) Benannte Vertragsstaaten: **BE DE FR GB NL**

(56) Entgegenhaltungen:
**EP - A - 0 016 305**
**EP - A - 0 023 595**
**EP - A - 0 023 596**
**DE - B - 1 178 529**

**J.C.S. CHEM. COMM., 1980, no. 8, 06-05-1980 J.F. RABOLT et al.: "Organic Metals: poly-(p-phenylene Sulphide) Hexafluoroarsenate", Seiten 347-348**

(73) Patentinhaber: **BASF Aktiengesellschaft, Carl-Bosch-Strasse 38, D-6700 Ludwigshafen (DE)**

(72) Erfinder: **Feichtmayr, Franz, Dr., Mundenheimer Strasse 158, D-6700 Ludwigshafen (DE)**
Erfinder: **Naarmann, Herbert, Dr., Haardtblick 15, D-6719 Wattenheim (DE)**
Erfinder: **Naegele, Dieter, Dr., Obere Jakobstrasse 8, D-6520 Worms 24 (DE)**
Erfinder: **Penzien, Klaus, Dr., Bensheimer Ring 18, D-6710 Frankenthal (DE)**

**EP 0 039 829 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Verfahren zur Herstellung elektrisch leitfähiger löslicher Heteropolyphenylene und deren Verwendung in der Elektrotechnik und zur antistatischen Ausrüstung von Kunststoffen

Die Erfindung betrifft ein Verfahren zur Herstellung von elektrisch leitfähigen löslichen Heteropolyphenylenen mit elektrischen Leitfähigkeitswerten größer als $10^{-2}$ S/cm und deren Verwendung in der Elektrotechnik zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bekannt, Polyphenylene durch oxidative Kupplung entsprechend der Literatur: »Macromolecular Syntheses Collective«, Vol. 1 (1979), Seiten 109 bis 110, Verlag John Wiley & Sons, und »Naturwissenschaften« 56 (1969), Seiten 308 bis 313, herzustellen. Außerdem ist die Herstellung von Polyphenylenen durch stufenweise Polykondensation nach R. Gehm und W. Kern in »Makromolekulare Chemie« 7 (1951), Seiten 46–61, beschrieben, wobei besonders einheitliche, para-verkettete methylsubstituierte Derivate erhalten werden, die nicht zusätzlich durch ortho- oder meta-verknüpfte Polymere verunreinigt sind. Die hochmolekularen Polyphenylene sind unlöslich und nichtschmelzbar und können daher nur sehr schwer verarbeitet werden.

Durch die Arbeiten von J. K. Stille, »Makromolekulare Chemie« 154, 49 (1972) wurde die Möglichkeit bekannt, durch Diels-Alder-Kondensation Heteropolyphenylene zu erhalten.

Es ist des weiteren bereits beschrieben worden, Poly-(p-phenylensulfide) durch Behandeln mit großen Mengen einer starken Lewis-Säure, wie $AsF_5$, in elektrisch p-leitende Produkte mit Leitfähigkeiten bis etwa $10^{0}$ S/cm zu überführen (vgl. J. C. S. Chem. Comm. (1980), Nr. 8, Seiten 347/348). Durch diese Behandlung mit $AsF_5$ werden die zuvor schmelz- und lösungsverarbeitbaren Poly(p-phenylensulfide) jedoch spröde und ebenfalls praktisch nicht mehr verarbeitbar. Auch ließen sich durch Umsetzung mit Elektronendonatoren, wie Natrium-Naphthalin, aus den Poly(p-phenylensulfiden) keine n-leitenden Produkte erhalten.

Aufgabe der vorliegenden Erfindung war es, lösliche Heteropolyphenylene durch einfaches Behandeln mit aktivierenden Zusatzstoffen in elektrisch leitfähige Polymere des p- oder n-leitenden Typs mit elektrischen Leitfähigkeiten größer als $10^{-2}$ S/cm umzuwandeln, ohne daß hierdurch die übrigen Eigenschaften der Ausgangspolymeren allzu stark nachteilig beeinflußt werden.

Diese Aufgabe wird erfindungsgemäß gelöst durch ein Verfahren zur Herstellung von elektrisch leitfähigen Heteropolyphenylenen mit elektrischen Leitfähigkeitswerten größer als $10^{-2}$ S/cm, bei dem den Heteropolyphenylenen unter Ausschluß von Wasserfeuchtigkeit und Sauerstoff 0,5 bis 5 Gewichtsprozent, bezogen auf das eingesetzte Heteropolyphenylen, eines aktivierenden Zusatzstoffes zugesetzt werden, welches dadurch gekennzeichnet ist, daß ein Heteropolyphenylen der allgemeinen Formel (I)

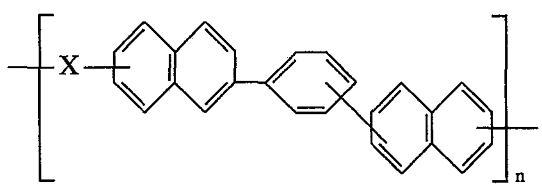

(I)

eingesetzt wird, in der X gleich O, S, Se, SO oder $SO_2$ sein kann und n = 2 bis 250, vorzugsweise 5 bis 50, ist.

Es hat sich gezeigt, daß in dem erfindungsgemäßen Verfahren bereits 5 Gewichtsprozent, bezogen auf das eingesetzte Heteropolyphenylen, als Obergrenze für den aktivierenden Zusatzstoff hinreichend sind.

Bevorzugt ist der aktivierende Zusatzstoff eine starke Lewis-Säure, ausgewählt aus
$AsF_5$, $SbF_5$, $UF_6$, $HClO_4$, $NO^+SbF_6^-$, $NO_2^+SbF_6^-$, $NO^+AsF_6^-$,
$NO_2^+AsF_6^-$, $NO^+PF_6^-$, $NO_2^+PF_6$, $NO^+BF_4^-$, $NO^+ClO_4^-$, $(CF_3)_2SO_4$,
2,4,6-Trinitrophenol, 2,4,6-Trinitrophenylsulfonsäure oder 2,4,6-Trinitrophenylcarbonsäure verwendet.
Bevorzugt ist auch ein Verfahren, bei dem als aktivierender Zusatzstoff Natrium, Kalium, Rubidium, Cäsium, Calcium, Barium oder deren Amide verwendet werden. Vorzugsweise werden beim Verwenden der Alkali- oder Erdalkalimetalle Hilfsflüssigkeiten wie Tetrahydrofuran, Dimethoxyglykol, Anthracen, Naphthalin oder 2-Methylstyrol, jeweils im Molverhältnis 1 : 1 bis 1 : 5, vorzugsweise 1 : 2 bis 1 : 3, zugesetzt.

Zur Herstellung der Heteropolyphenylene der allgemeinen Formel (I) geht man von Hydroxicumarinen aus. Durch Diels-Alder-Kondensation mit Diäthinylphenylen werden höherkondensierte aromatische Diole der allgemeinen Formel (II)

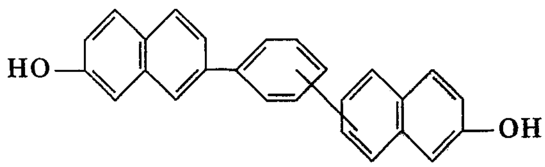

(II)

hergestellt und diese über klassische Reaktionen durch OH-Substitution und anschließende Kupplung in die löslichen Heteropolyphenylene der Formel (I) überführt,

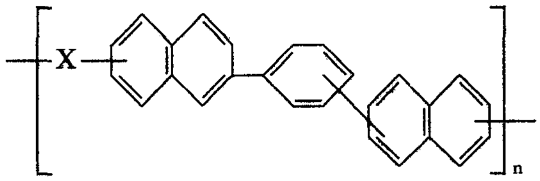

(I)

wobei n = 2 bis 250, vorzugsweise 5 bis 50, und X = O, S, Se, SO oder $SO_2$ ist.

Das Einarbeiten der aktivierenden Zusatzstoffe erfolgt stets unter Ausschluß von Feuchtigkeit (Wasser) sowie Sauerstoff (Luft). Es wird daher vorzugsweise unter Argonatmosphäre gearbeitet. Die gegebenenfalls mitverwendeten Lösungsmittel werden nach dem Einarbeiten bei Temperaturen unter 30° C im Vakuum abgezogen.

Durch die genannten aktivierenden Zusatzstoffe können elektrische Leitfähigkeitsanstiege von einigen Größenordnungen erreicht werden. Die Ausgangsleitfähigkeiten der Heteropolyphenylene der Formel (I) betragen ca. $10^{-13}$ S/cm. Nach der Zugabe der aktivierenden Zusatzstoffe besitzen die Heteropolyphenylene elektrische Leitfähigkeiten größer als $10^{-2}$ S/cm.

Die erfindungsgemäß hergestellten elektrisch leitfähigen Heteropolyphenylene mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch den Zusatz der starken Lewis-Säuren zu den Heteropolyphenylenen entstehen sogenannte P-Leiter, durch den Zusatz der Alkali- oder Erdalkalimetalle oder deren Amide entstehen sogenannte n-Leiter.

Die in den Beispielen genannten Teile sind Gewichtsteile; die Mengen der Zusatzstoffe sind in Molprozenten angegeben.

## Beispiele 1 – 15

10 Teile des in der nachfolgenden Tabelle gekennzeichneten Heteropolyphenylens werden unter Argonatmosphäre und Ausschluß von Feuchtigkeit mit dem jeweiligen, in der nachfolgenden Tabelle angegebenen Zusatzstoff versetzt. Die Messung der elektrischen Leitfähigkeit erfolgt nach F. Beck, »Ber. Bunsengesellschaft, Phys. Chem.« 68, 558 bis 567 (1964).

Bei den verwendeten Heteropolyphenylenen handelt es sich um die Typen:

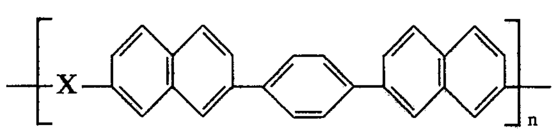

(Ia)

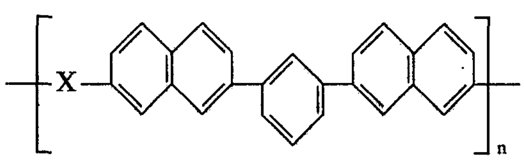

(Ib)

| Beispiel Nr. | Heteropolyphenylen | Aktivierender Zusatzstoff Art und Menge Mol-% | | Leitfähigkeit S/cm 30°C vor dem Zusatz | Leitfähigkeit S/cm 30°C nach dem Zusatz |
|---|---|---|---|---|---|
| 1 | Ia<br>n = ca. 10<br>X = 0 | $AsF_5$ | 0,2 | $10^{-13}$ | $0{,}5 \cdot 10^{-1}$ |
| 2 | Ia<br>n = ca. 15<br>X = 0 | $SbF_5$ | 0,4 | $10^{-13}$ | $0{,}8 \cdot 10^{-2}$ |
| 3 | Ia<br>n = ca. 15<br>X = S | $BF_3$ | 0,5 | $10^{-13}$ | $1{,}2 \cdot 10^{-2}$ |
| 4 | Ia<br>n = ca. 35<br>X = S | $NO_2^+SBF_6$ | 0,2 | $10^{-11}$ | $7{,}8 \cdot 10^{+1}$ |
| 5 | Ia<br>n = ca. 15<br>X = $SO_2$ | $NO^+SbF_6$ | 0,2 | $10^{-12}$ | $2{,}4 \cdot 10^{+1}$ |
| 6 | Ia<br>n = ca. 20<br>X = Se | $CF_3SO_3H$ | 0,2 | $10^{-12}$ | $0{,}5 \cdot 10^{+1}$ |
| 7 | Ia<br>n = ca. 10<br>X = 0 | Na | 0,5 | $10^{-13}$ | $0{,}2 \cdot 10^{-1}$ |
| 8 | Ib<br>n = ca. 20<br>X = 0 | $AsF_5$ | 0,2 | ca. $10^{-13}$ | $0{,}7 \cdot 10^{-1}$ |
| 9 | Ib<br>n = ca. 25<br>X = 0 | $AsF_5$ | 0,2 | ca. $10^{-13}$ | $1{,}4 \cdot 10^{-1}$ |
| 10 | Ib<br>n = ca. 35<br>X = 0 | $AsF_5$ | 0,2 | ca. $10^{-13}$ | $2{,}9 \cdot 10^{-1}$ |
| 11 | Ib<br>n = ca. 50<br>X = 0 | $AsF_5$ | 0,2 | ca. $10^{-13}$ | $3{,}9 \cdot 10^{+1}$ |
| 12 | Ib<br>n = ca. 20<br>X = S | $AsF_5$ | 0,2 | ca. $10^{-13}$ | $4{,}2 \cdot 10^{-1}$ |
| 13 | Ib<br>n = ca. 80<br>X = S | $SbF_5$ | 0,2 | ca. $10^{-12}$ | $9{,}6 \cdot 10^{+1}$ |
| 14 | Ib<br>n = ca. 35<br>X = Se | $AsF_5$ | 0,2 | ca. $10^{-11}$ | $1{,}9 \cdot 10^{+2}$ |
| 15 | Ib<br>n = ca. 20<br>X = 0 | $H_2SO_4$ | 0,3 | ca. $10^{-13}$ | $0{,}4 \cdot 10^{-1}$ |

**Patentansprüche:**

1. Verfahren zur Herstellung von elektrisch leitfähigen Heteropolyphenylenen mit elektrischen Leitfähigkeitswerten größer als $10^{-2}$ S/cm, bei dem den Heteropolyphenylenen unter Ausschluß von Wasserfeuchtigkeit und Sauerstoff 0,5 bis 5 Gew.-%, bezogen auf das eingesetzte Heteropolyphenylen, eines aktivierenden Zusatzstoffes zugesetzt werden, dadurch gekennzeichnet, daß ein Heteropolyphenylen der allgemeinen Formel (I)

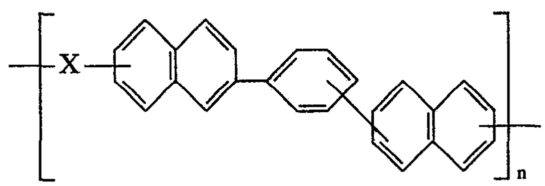

(I)

eingesetzt wird, worin X gleich O, S, Se, SO oder $SO_2$ sein kann und n = 2 bis 250, vorzugsweise 5 bis 50 ist.

2. Verfahren nach Anspruch 2, dadurch gekennzeichnet, daß als aktivierender Zusatzstoff eine starke Lewis-Säure ausgewählt aus
$AsF_5$, $SbF_5$, $UF_6$, $HClO_4$, $NO^+SbF_6^-$, $NO_2^+SbF_6$, $NO^+AsF_6^-$,
$NO_2^+AsF_6^-$, $NO^+PF_6^-$, $NO_2^+PF_6^-$, $NO^+BF_4^-$, $NO^+ClO_4^-$, $(CF_3)_2SO_4$,
2,4,6-Trinitrophenol, 2,4,6-Trinitrophenylsulfonsäure und 2,4,6-Trinitrophenylcarbonsäure zugesetzt wird.

3. Verfahren nach Anspruch 1, dadurch gekennzeichnet, daß den Heteropolyphenylenen (I) als aktivierende Zusatzstoffe Natrium, Kalium, Rubidium, Cäsium, Calcium, Barium oder deren Amide zugesetzt werden.

4. Verfahren nach Anspruch 4, dadurch gekennzeichnet, daß Na, K, Rb, Cs, Ca, Ba oder deren Amide in Tetrahydrofuran, Dimethoxyglykol, Anthracen, Naphthalin oder 2-Methylstyrol, jeweils im Molverhältnis 1 : 1 bis 1 : 5, vorzugsweise 1 : 2 bis 1 : 3, zugesetzt werden.

5. Verwendung der nach einem der Ansprüche 1 bis 4 hergestellten, elektrisch leitfähigen Heteropolyphenylene in der Elektrotechnik zur Herstellung von Sonnenzellen, zur Umwandlung und Fixierung von Strahlung und zur Herstellung elektrischer und magnetischer Schalter.

6. Verwendung der nach einem der Ansprüche 1 bis 4 hergestellten, elektrisch leitfähigen Heteropolyphenylene zur antistatischen Ausrüstung von Kunststoffen.

**Claims**

1. A process for the production of electrically conductive heteropolyphenylenes having electrical conductivities greater than $10^{-2}$ S/cm, from 0.5 to 5% by weight, based on the heteropolyphenylene used, of an activating substance being added to the heteropolyphenylene in the absence of moisture and oxygen, wherein there is used a heteropolyphenylene of the general formula (I)

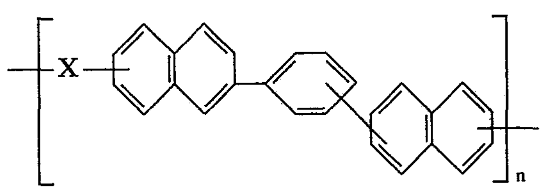

(I)

where X may be O, S, Se, SO or $SO_2$, and n is 2 to 250, preferably 5 to 50.

2. A process as claimed in claim 2 (read 1), wherein a strong Lewis acid selected from
$AsF_5$, $SbF_5$, $UF_6$, $HClO_4$, $NO^+SbF_6^-$, $NO_2^+SbF_6$, $NO^+AsF_6^-$,
$NO_2^+AsF_6^-$, $NO^+PF_6^-$, $NO_2^+PF_6^-$, $NO^+BF_4^-$, $NO^+ClO_4^-$, $(CF_3)_2SO_4$,
2,4,6-trinitrophenol, 2,4,6-trinitrophenylsulfonic acid and 2,4,6-trinitrophenylcarboxylic acid is added as activating substance.

3. A process as claimed in claim 1, wherein sodium, potassium, rubidium, cesium, calcium, barium or an amide thereof is added to the heteropolyphenylene (I) as activating substance.

4. A process as claimed in claim 4 (read 3), wherein Na, K, Rb, Cs, Ca, Ba or an amide thereof in tetrahydrofuran, dimethoxyglycol, anthracene, naphthalene or 2-methylstyrene is added in a molar ratio of from 1 : 1 to 1 : 5, preferably from 1 : 2 to 1 : 3.

5. The use of the electrically conductive heteropolyphenylenes produced as claimed in any of claims 1 to 4 in electrical engineering for the production of solar cells, for the conversion and fixation of radiation, and for the production of electrical and magnetic switches.

6. The use of the electrically conductive heteropolyphenylenes produced as claimed in any of claims 1 to 4 for the antistatic finishing of plastics materials.

**Revendications**

1. Procédé de préparation d'hétéropolyphénylènes conducteurs de l'électricité avec des conductivités électriques supérieures à $10^{-2}$ S/cm, dans lequel on incorpore aux hétéropolyphénylènes, à l'abri de l'humidité et de l'oxygène, entre 0,5 et 5% du poids de l'hétéropolyphénylène mis en oeuvre d'un additif activant, caractérisé en ce que l'hétéropolyphénylène utilisé répond à la formule générale (I)

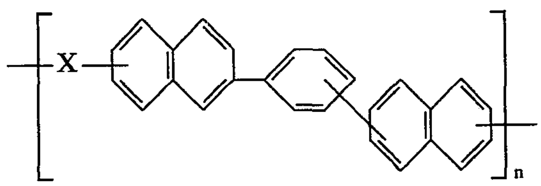

(I)

dans laquelle X peut désigner O, S, Se, SO ou $SO_2$ et n vaut 2 à 250 et de préférence 5 à 50.

2. Procédé suivant la revendication 2 (lire 1), caractérisé en ce que l'additif activant est un acide de Lewis fort, choisi parmi
$AsF_5$, $SbF_5$, $UF_6$, $HClO_4$, $NO^+SbF_6^-$, $NO_2^+SbF_6^-$, $NO^+AsF_6^-$,
$NO_2^+AsF_6^-$, $NO^+PF_6^-$, $NO_2^+PF_6^-$, $NO^+BF_4^-$,
$NO^+ClO_4^-$, $(CF_3)_2SO_4$,
le trinitro-2,4,6 phenol, l'acide trinitro-2,4,6 phenyl-sulfonique et l'acide trinitro-2,4,6 phenyl-carboxylique.

3. Procédé suivant la revendication 1, caractérisé en ce que l'on incorpore aux hétéropolyphénylènes (I), en tant qu'additif activant, du sodium, du potassium, du rubidium, du césium, du calcium ou du baryum ou un amide de ceux-ci.

4. Procédé suivant la revendication 4 (lire 3), caractérisé en ce que le sodium, le potassium, le rubidium, le césium, le calcium ou le baryum ou leurs amides sont incorporés dans du tétrahydrofuranne, du diméthoxyglycol, de l'anthracène, du naphthalène ou du méthyl-2 styrène dans un rapport molaire compris entre 1 : 1 et 1 : 5 et de préférence entre 1 : 2 et 1 : 3.

5. Utilisation des hétéropolyphénylènes conducteurs de l'électricité, préparés selon l'une des revendications 1 à 4, dans le domaine électro-technique pour la fabrication de cellules solaires, pour la transformation et la fixation de radiations et pour la fabrication de commutateurs électriques et magnétiques.

6. Utilisation des hétéropolyphénylènes conducteurs de l'électricité, préparés selon l'une des revendications 1 à 4, pour l'apprêtage antistatique de matières plastiques.